Europäisches Patentamt

European Patent Office

Office européen des brevets

(11) Publication number: **0 094 426**
**B1**

(12) **EUROPEAN PATENT SPECIFICATION**

(45) Date of publication of patent specification: **05.08.87**

(51) Int. Cl.⁴: **H 01 L 21/205**

(21) Application number: **83900227.6**

(22) Date of filing: **19.11.82**

(86) International application number:
**PCT/US82/01640**

(87) International publication number:
**WO 83/01865 26.05.83 Gazette 83/13**

(54) **BANDGAP CONTROL IN AMORPHOUS SEMICONDUCTORS.**

(30) Priority: **20.11.81 US 323585**
**07.01.82 US 337627**

(43) Date of publication of application:
**23.11.83 Bulletin 83/47**

(45) Publication of the grant of the patent:
**05.08.87 Bulletin 87/32**

(84) Designated Contracting States:
**AT BE CH DE FR GB LI LU NL SE**

(56) References cited:
**GB-A-2 083 701**
**US-A-4 237 150**
**US-A-4 237 151**
**US-A-4 339 470**
**US-A-4 357 179**
**US-A-4 363 828**

**Journal De Physique, Colloque Ce, supplement au no. 10, Tome 42, issued October 1981**

(73) Proprietor: **CHRONAR CORPORATION**
**P.O. Box 177**
**Princeton, NJ 08540 (US)**

(72) Inventor: **DALAL, Vikram L.**
**K22 Shirley Lane**
**Lawrenceville, NJ 08648 (US)**
Inventor: **AKHTAR, M.**
**180 Franklin Corner Road Apt. J1**
**Lawrenceville, NJ 08648 (US)**
Inventor: **GAU, Shek-Chung**
**40 Slayback Dr.**
**Princeton JCT., NJ 08550 (US)**
Inventor: **RAMAPRASAD, Kackadasam R.**
**66 Linden Lane**
**Princeton, NJ 08540 (US)**

(74) Representative: **Siebert . Grättinger & Bockhorni**
**Postfach 1649 Almeidaweg 35**
**D-8130 Starnberg (München) (DE)**

Courier Press, Leamington Spa, England.

## Description

The invention relates to a method of production of amorphous semiconductors with a specified bandgap wherein at least one higher order semiconductane contained in a gaseous phase mixture (G) is introduced in a reaction chamber wherein a substrate is provided, said substrate being subjected to controlled heating.

Semiconductors have an extended region of discontinuity in their internal energy levels between their valence and conduction bands. This region of discontinuity is known as a "bandgap". It determines how a device made from the material will respond to external stimuli.

In order to realize the most efficient interchange or interaction between a device and its source of activation, for example, between the solar spectrum and a photo responsive device, it is advantageous to match the bandgap of the device to that of the energizing spectrum. This procedure is analogous to the matching of electrical elements in order to obtain maximum energy transfer.

Unfortunately, previously produced amorphous semiconductors have been characterized by undesirable bandgaps. It has not been possible in the case of silicon, for example, to provide bandgaps that could achieve the most efficient use of the solar spectrum with devices made with the semiconductors.

To achieve precision control over the bandgaps of amorphous silicon, prior attempts have been made (compare Journal de Physique, Colloque C4, suppliment au n° 10, Tome 42, issued October 1981) to produce such silicon with desirable characteristics by hydrogenating the silicon. Moreover, it is known (US—A—4 237 150, US—A—4 237 151) to form a gaseous mixture of atomic hydrogene and atomic silicon by firmly decomposing Silane ($SiH_4$) or other gases comprising H and Si, at elevated temperatures widely above 1300°C, and preferably in a vacuum. The gaseous mixture formed is deposited onto a substrate outside the source of thermal decomposition to form hydrogenetic amorphous silicon. These examples, however, suffer from the disadvantage of requiring the use of relatively high temperatures.

The invention as claimed is intended to remedy this drawback. It solves the problem of how to achieve the production of hydrogenated amorphous silicon with a specified bandgap at comparatively low temperatures.

In accomplishing this object in accordance with the claims, the invention provides a method of preparing an amorphous semiconductor with a specified bandgap by the pyrolytic decomposition of one or more gaseous phase polysemiconductanes at a specified temperature for each desired bandgap. The pyrolytic decomposition forms a deposit over a reaction range of temperature between 300°C and 500°C within the total range of temperature over which the deposition can take place.

In accordance with a further aspect of the invention, the deposition takes place in a reactor which is maintained at a different temperature than the average temperature of the deposit that is formed. The deposit is desirably made on a substrate within the reactor, and the deposition temperature is substantially that of the substrate.

In accordance with yet another aspect of the invention, the temperature of the reactor is maintained at a different level than the temperature of the substrate. The reactor may be maintained at a temperature which is greater than or less than that of the reaction, with a difference in the two temperatures being maintained over the time of the reaction. The reaction desirably takes place in the temperature range between about 300°C and 475°C. The reaction temperature can be permitted to vary within a prescribed range, which can vary between about 5 percent above and about 5 percent below the average temperature of the reaction.

The semiconductanes which are pyrolytically decomposed can be diluted with an inert gas, such as argon, helium, neon, xenon, or hydrogen. The semiconductanes are desirably selected from the class of silanes, germanes and mixtures of the two. The gas from which the deposit takes place can be in the form of a stream which flows continuously into and out of the reactor. The gas may be made to directly impinge on a heated substrate by, for example, the use of a directive nozzle.

Alternatively the gas may be static within the reactor.

The gaseous medium from which the deposit takes place may include a suitable dopant. Appropriate dopants are the trihydrides or trihalides of phosphorus, arsenic and tin, as well as diborane. Organometallic compounds of elements such as aluminium and gallium may also be employed.

### Detailed Description

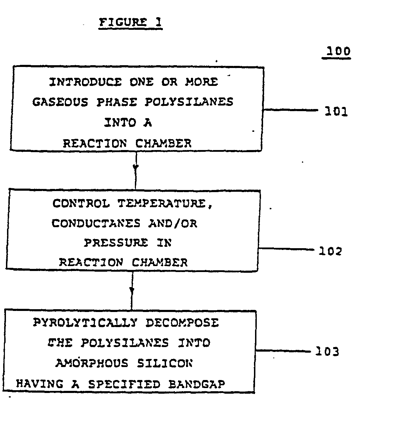

With reference to the drawings, a flow chart 100 for the general practice of the invention is set forth in FIGURE 1. The process begins with the introduction of a gaseous phase mixture containing at least one higher order silane into a reaction chamber, as illustrated in block 101. In the reaction chamber the gaseous phase mixture has its desired temperature and/or pressure controlled in accordance with block 102. The result, as indicated in block 103, is the pyrolytic decomposition of the gaseous phase mixture to deposit amorphous silicon having a specified bandgap.

It will be understood that the process is equally applicable to other semiconductanes, such as germanes, with the deposition temperature being adjusted to be suitable for the material being pyrolytically decomposed. A similar consideration applies to the pressure that is employed.

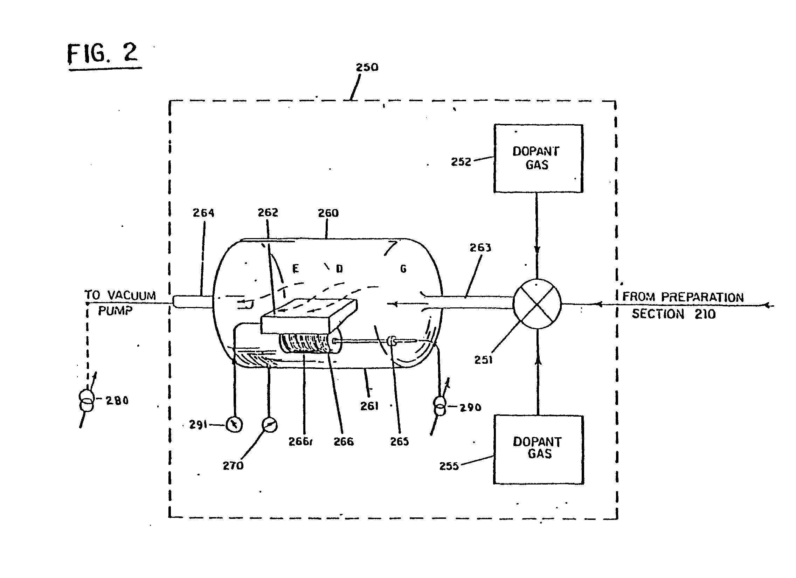

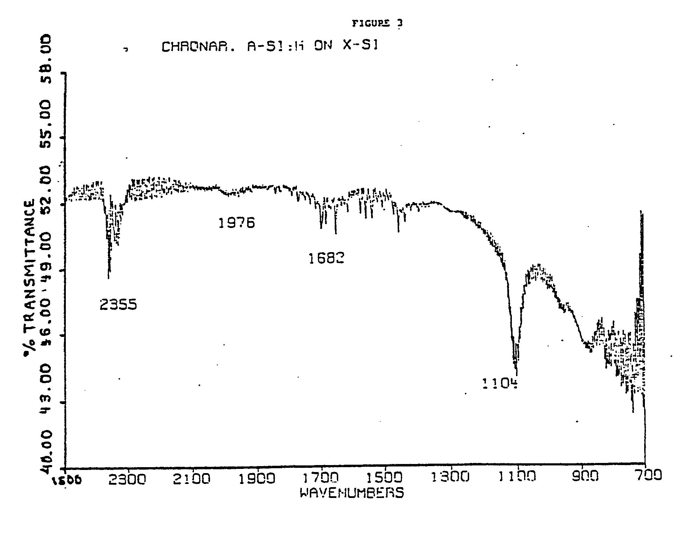

An illustrative arrangement 250 for producing semiconductors with controlled bandgaps is illustrated in FIGURE 2. The semiconductanes to be converted, including higher order silanes, are prepared in a preliminary section 210 (not shown) and introduced at a mixing valve 251. The latter permits the controlled introduction either simultaneously or at desired intervals of time, of dopant gases from source 252 and/or 255. The result is a gaseous stream which is applied at an inlet 263 of a reaction chamber 260. The incoming gaseous stream, indicated by the arrow G, is drawn over the substrate 262 by the action of a vacuum pump 280. In addition, the substrate 262 is subjected to controlled heating by a heater 266r in a holder 266. A current is applied to the heater 266r from an adjustable source 290. The temperature of the substrate is monitored by a gauge 291 which illustratively extends to the substrate 262. A further gauge 264 for the vacuum pump 280 gives an indication of the pressure within the reaction chamber 260.

As the incoming gaseous phase mixture G is drawn over the heated substrate 262 it pyrolytically decomposes and forms an amorphous semiconductor on the upper surface of the substrate, as indicated by the dashed line arrows D. The portion of the gaseous phase mixture that does not participate in the pyrolytic decomposition is drawn from the chamber into the vacuum pump 280 as exhaust gas E.

With the pressure indicated by the pressure gauge 270 held at a fixed level by constant operation of the vacuum pump 280, and with the substrate maintained at a prescribed temperature T as indicated by the temperature gauge 291, the semiconductor material that becomes pyrolytically deposited on the substrate has a prescribed bandgap. As the substrate temperature is changed and held constant, the bandgap of the deposited material changes accordingly.

The control that is achieved in accordance with the invention over the bandgap appears to result from the changes that are controllably made in the amount of hydrogen bonded to the semiconductane atoms of the deposit. While it has been known that many amorphous semiconductors, such as those produced by gaseous discharge, have hydrogen compensated defects because of ion bombardment, it has been believed that amorphous films produced by pyrolytic decomposition contained little hydrogen bonding. It was further believed that at low pressure levels where there was virtually no ion bombardment in the pyrolytic process, there was no hydrogen bonding in the resulting amorphous silicon.

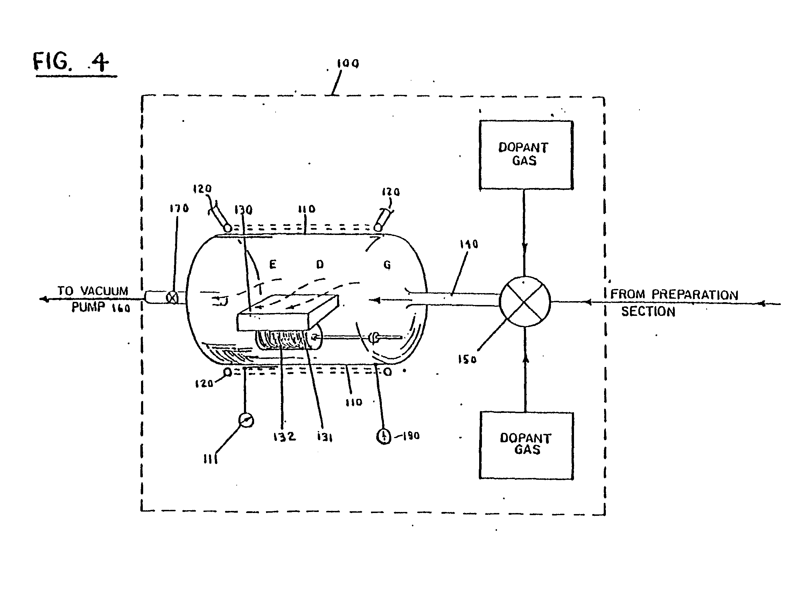

Our tests of the infra-red spectrum of pyrolytic amorphous silicon have indicated the presence of slight amounts of hydrogen. We believe that this is only necessary to compensate for certain of the amorphous bonds that are created in the pyrolytic decomposition process. In other words, because of the amorphous nature of the resulting material an occasional hydrogen bond appears to be created because of the ned to compensate for structural irregularities in the resultant materials. In any event, our speculation as to the nature of the hydrogen bonding created in amorphous semiconductors formed by pyrolytic decomposition appears to be confirmed by the illustrative infra-red spectrum of FIGURE 3, in which the percentage transmittance is plotted against wave numbers in reciprocal centimeters. The distinct absorption at 1978 wave numbers is characteristic of silicon hydride (Si:H) stretched bonding in which the bond between Si and H obtained is subject to linear oscillatory extensions.

FIGURE 3 is a computer print in which the computer was programmed to note any significant absorptions. FIGURE 3 shows significant absorptions at 2355, 1682 and 1104 wave numbers, in addition to the significant silicon hydride absorption at 1978 wave numbers.

By contrast with amorphous semiconductors produced for example, by techniques which cause a significant amount of ion bombardment and a substantial number of defects which require compensation, the relative absence of such defects in the case of pyrolytically decomposed semiconductanes results in bandgap control by changing the amounts of hydrogen, and not defect compensation. We have found that control over temperature during pyrolytic decomposition allows the resulting material to retain its photovoltaic properties. This is significantly different than, for example, glow discharge amorphous silicon in which an increased temperature results in the reduction in the desired photoelectric effect.

One measure of the improved performance of materials with controlled bandgaps in accordance with the invention is that as temperature is increased we have been able to measure both a reduction in bandgap and an increase in short-circuit current. We have speculated that this results because an increase in temperature leads to greater coherence and ordering in the semiconductor structure, requiring a reduced amount of hydrogen for defect compensation. This is opposite to what has been observed for amorphous silicon produced in other ways, such as glow discharge, in which the excessive defect condition caused by ion bombardment appears to prevent the material from achieving greater coherence as temperature is increased.

An illustrative reaction chamber 100 for producing semiconductors with controlled bandgaps is illustrated in FIGURE 4. The reaction chamber 100 is used in a process that begins with the introduction of a gaseous medium containing at least one higher order semiconductane. In the reaction chamber 100 the gaseous medium is controlled in temperature and/or pressure to being about a pyrolytic deposit of semiconductive material having a specified bandgap.

It will be understood that the process is equally applicable to other semiconductanes, such as germanes, with the deposition temperature being adjusted according to the material that is being pyrolytically decomposed. Similar adjustments are made in the pressure that is employed.

The reactor 100 is of the hot-wall epitaxial type, i.e., the decomposition of gases takes place at the wall of the reactor, and a deposit is formed on the substrate 130. The wall or closure 110 of the reactor 100, typically of quartz, is surrounded over its principal cylindrical body portion by a heating coil 120. The latter is used to apply heat directly to the wall 110 and maintain it at a prescribed temperature level. This is by contrast with the similar reactor 250 shown in FIGURE 2.

The heating effect from the coil 120 is radiated from the wall 110 onto the substrate 130. Where desired the substrate may have an additional heating effect produced by an internal heating coil 132, or a cooling effect by an internal coolant pipe, which is substituted for the coil 132.

The temperature of the wall is monitored by a thermocouple 111, while the temperature of the substrate is monitored by a thermocouple 131. Semiconductanes that are to be pyrolytically decomposed in accordance with the invention are introduced into the reactor 100 at an inlet 140 through an appropriate mixing valve 150. The gaseous medium is exhausted through a vacuum pump 160 through an outlet valve 170. Pressure within the chamber 100 is monitored by a gauge 180.

The pyrolytic deposit formed on the substrate 130 may be produced by either static or dynamic action of the gaseous medium. In static deposition the semiconductanes are introduced into the evacuated reactor 100 through the valve 150. The exhaust valve 170 and the inlet valve 150 are then shut, causing a specified volume of gaseous medium to be trapped in the chamber 100. Because of the heating effect of the coil 120, the trapped gas decomposed on both the wall 110 and the substrate 130. The result is a desired amorphous silicon hydride film having a specified bandgap. The static system has the advantage of economizing on the volume and pumping of the gaseous medium.

In the dynamic processing arrangement, the gaseous medium flows continuously through the chamber 100 at a desired rate determined by the settings of the inlet valve 150 and the exhaust valve 170. As a result a new reaction mixture is continuously introduced into the chamber 100 and all components of the gaseous medium maintain their relative partial pressures. The dynamic arrangement, however, has the disadvantage of some waste of the gaseous medium since a considerable amount of the gas is exhausted through the vacuum pump 160 without decomposing to form the semiconductor deposit.

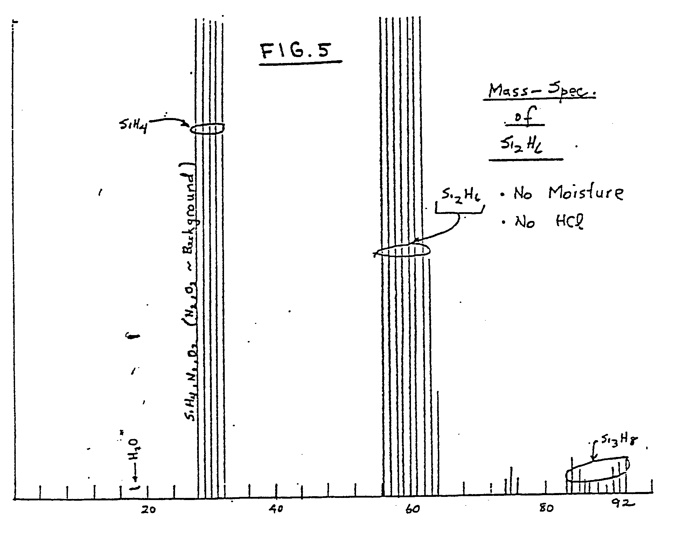

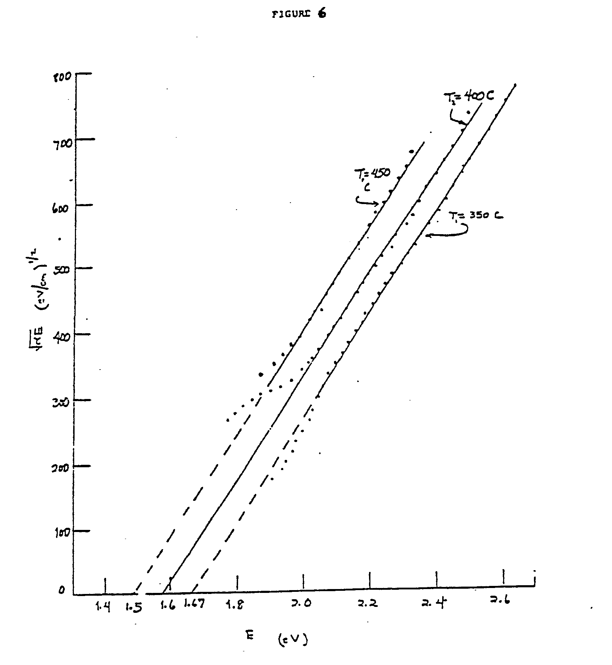

An illustrative gaseous medium has the mass-spectrometer plot of FIGURE 5. As noted from FIGURE 5 the medium is a mixture of monosilanes, disilanes and trisilanes. The monosilanes are indicated by peaks between mass numbers 28 and 34. The disilanes are indicated by peaks between mass numbers 56 and 64, while the trisilanes have peaks between mass numbers 84 and 93. The mass-spectrometer plot of FIGURE 5 also indicates the absence of moisture and hydrogen chloride. For example, if moisture were present, it would be indicated by peaks in the vicinity of mass number 18. As is apparent, there is no indication at that particular mass number position. Since disilanes, e.g. the gaseous components peaking between mass numbers 56 and 64 are ordinarily accompanied by significant amounts of moisture and hydrogen chloride, the mixture of FIGURE 5 results from the preparation of the higher order silanes under conditions which limit the creation of impurities or result from trapping of the impurities in standard cold traps.

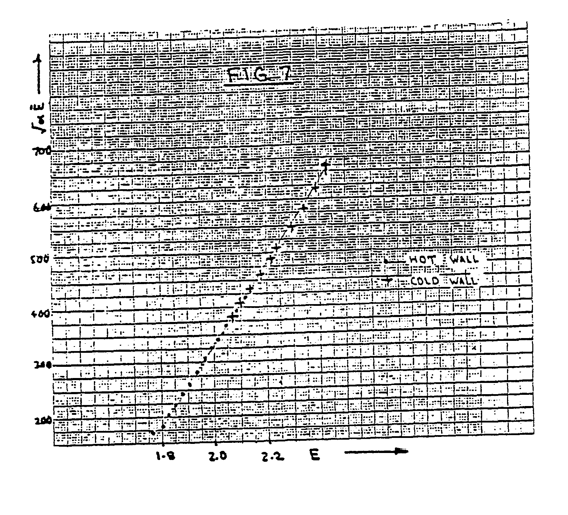

When the gaseous medium of FIGURE 5 is introduced into the hot-wall reactor of FIGURE 4 and controlled pyrolytic decomposition takes place at three different substrate temperatures, the results are as plotted in FIGURE 6, where the square root of the absorption coefficient (alpha) times energy in electron volts (E) is plotted against energy. The illustrative curves $T_1$ through $T_n$, where $T$ represents the relatively fixed temperature at which pyrolytic decomposition takes place, are shifted in the direction of lower energy, corresponding to the bandgap shift, as the temperature of the controlled deposition takes place. The curve $T_1$ for a temperature of 375°C., the curve $T_2$ for a temperature of 425°C., and the curve $T_3$ for a temperature of 450°C., all have essentially the same slope measured in terms of the ration of the change in the square root of the absorption coefficient times energy to the change in energy. This is significantly different from experience with glow discharge and other materials in which a significant decrease in energy gap is accompanied by a shallower slope and hence a reduced photovoltaic effect. The distinct variations in energy gap for the different temperatures of pyrolytic decomposition is attributed to the different concentrations of hydrogen that result in the deposits.

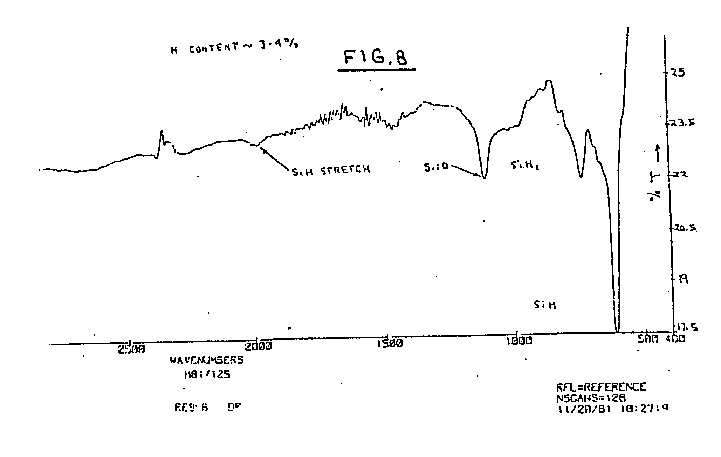

It is to be noted that for the plots of FIGURE 6 the various readings are indicated by dots to represent absorption data for films deposited using a heated wall reactor. Substantially similar results are obtained for operations using a cold-wall reactor as indicated in FIGURE 7 where data for cold-wall operation is represented by crosses. In all cases, the temperature at which the pyrolytic decomposition takes place is about 425°C for the substrate where the deposit forms. Both hot-wall and cold-wall deposition produce an absorption curve with a relatively constant slope.

The test results indicate that the controlling factor in determining the bandgap of the deposited material is that the substrate temperature be the same whether the reaction chamber is of the cold-wall or the hot-wall type. The substrate temperature should be maintained within ten degrees above and below the nominal value of the desired bandgap.

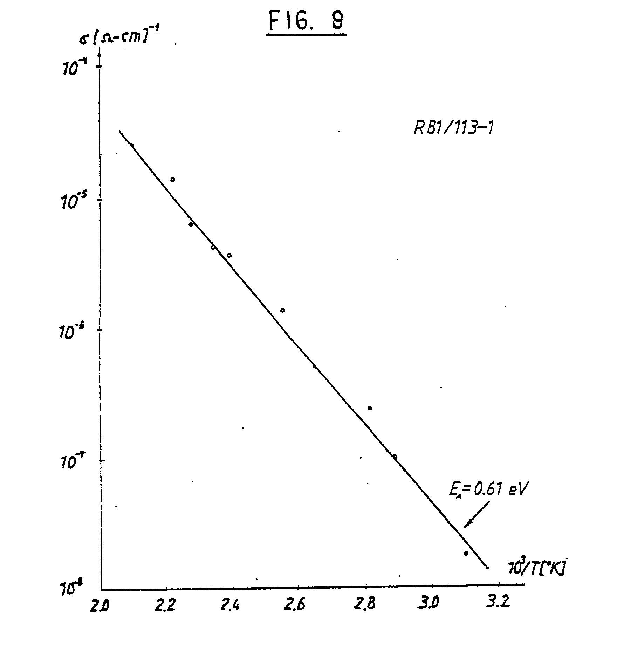

An infra-red spectrum of an amorphous silicon hydride film deposited in the reactor of FIGURE 4 on a crystalline silicon substrate is shown in FIGURE 8. The spectrum has a characteristic silicon hydride stretch bond at 1980 wave numbers/reciprocal centimeters. It is to be noted that other absorption bands centered at 1170 and 750 wave numbers are attributable to suitable oxide bonding in the crystalline silicon substrate and consequently play no role in the silicon hydride that produces bandgap control according to the invention.

FIGURE 8 also shows a minor absorption peak at 870 wave numbers. This is likely to be substrate absorption. In any event, even if it could be associated with silicon-dihydrogen bonding, its effect would be too insignificant to adversely influence the silicon hydride that is formed.

The invention is illustrated further with reference to the following non-limiting examples:

### Example I

A mixture of semiconductanes including monosilanes, disilanes and trisilanes was prepared. The mixture was subjected to pyrolytic decomposition in a heated-wall reaction chamber to form a semiconductor film on a silicon crystalline substrate at a temperature of about 425°C and a pressure of 40 Torrs: (1 Torr = 133.32 Pa). The body of the reaction chamber was maintained at a fixed temperature above that of the substrate. An epitaxial film of amorphous silicon was deposited on the substrate and found to have a bandgap in the range from about 1.58 to about 1.60 electron volts.

### Example II

Example I was repeated except that the reaction chamber was maintained at a relatively constant temperature below that of the substrate. The result was substantially the same as the result for Example I.

### Example III

Example I was repeated except that the reaction chamber was unheated, and was of the cold-wall type. The results were the same as for Example I.

### Example IV

The preceding examples were repeated except that the substrate temperature was permitted to vary in the range from about 2 percent above and 2 percent below the reaction temperature. The result was substantially the same as for Example I.

### Example V

The foregoing examples were repeated except that inert gases were used as diluents of the gaseous medium. The results were substantially the same as before, except that the growth rates of the resulting film were lower.

### Example VI

The foregoing examples were repeated except that n-type dopant gases diluted in argon or hydrogen were introduced into the gases medium. The results were substantially the same as before, except that the reaction rate was slower.

### Example VII

The foregoing examples were repeated using a static gaseous medium in the reaction chamber. The results were substantially the same as for the preceding examples.

### Example VIII

The foregoing examples were repeated varying the flow rate through the reaction chamber. The results were substantially the same as before.

### Example IX

The foregoing examples were repeated except that the substrate temperature was increased to about 475°C and held at substantially that level during pyrolytic decomposition. The resulting amorphous silicon deposit was found to have a reduced bandgap in the range from about 1.48 to about 1.50 electron volts.

### Example X

The foregoing examples were repeated except that the temperature of pyrolytic decomposition was decreased to 375°C. The result was a substantial increase in bandgap to the level of about 1.63 to about 1.65 electron volts.

As noted above in connection with Example V the presence of monosilanes in the gaseous medium appeared to have only the effect of slowing the rate of pyrolysis. In any case, there was no adverse effect on the amorphous silicon hydride film that resulted. It is believed that the monosilanes do not participate in the decomposition since they do not decompose substantially at the test temperature in the range from about 300°C to about 475°C. It is apparent that if the composition is successfully maintained at higher temperatures where monosilanes do decompose, their presence will add to the resulting film deposit. In addition, disilane is known to decompose into silane and silane-dihydride, so that the presence of independent silanes merely supplements the silanes that are produced by the decomposition of higher order silanes, and may slow the reaction down somewhat.

In connection with Example V, it has been noted that the addition of inert gases such as argon only affect the growth rate of the pyrolytically produced films. This comes about because there is a reduction in the partial pressure of the higher order silanes for a given total pressure. Other inert gases such as helium, nenon, xenon and hydrogen have a similar effect.

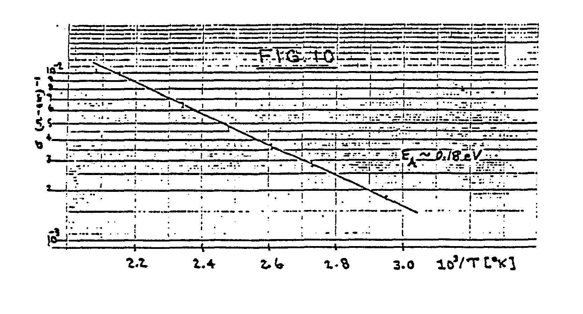

In connection with the introduction of dopants into the gaseous medium as in Example VI, FIGURES 9 and 10 compare the conductivities of n-type doped and undoped films as a function of temperature. In the case of FIGURE 9, doped film was prepared using phosphine and the gaseous medium had the approximate composition of FIGURE 5, including monosilanes. As seen from FIGURE 10, the conductivity of an undoped film is comparatively low and the activation energy is comparatively high, indicating that the material is intrinsic or undoped. It has a Fermi level of approximately 0.61 electron volts below the conduction band and is in fact the middle of the bandgap. By contrast, for the doped film of FIGURE 9 , there is a comparatively smaller activation energy of 0.18 electron volts, indicating that the Fermi level has moved towards the conduction band as a result of the doping. Other suitable dopants, in addition to phosphine, include stibine, arsine and phosphorus trichloride for producing n-type material, and diborane, together with organometallic compounds of aluminum and gallium for producing p-type material.

## Claims

1. Method of production of amorphous semiconductors with a specified bandgap wherein at least one higher order semiconductane contained in a gaseous phase mixture (G) is introduced in a reaction chamber (100; 260) wherein a substrate (130; 262) is provided, said substrate being subjected to controlled heating, characterized in that said gaseous phase mixture (G) pyrolytically decomposes over said heated substrate (130; 262) and forms an amorphous semiconductor on the upper surface of said substrate (130;262) within a reaction temperature range between 300°C and 500°C, the temperature of said substrate being changed and held constant whereby the bandgap of said deposited material changes accordingly.

2. The method in accordance with claim 1 wherein said semiconductor is selected from the class consisting of silicon or germanium, or an alloy thereof.

3. The method of claim 1 or 2 wherein the bandgap decreases as the midpoint of said limited range of temperature is increased.

4. The method of any claims 1—3 wherein the bandgap decreases and the amount of hydrogen decreases as the temperature increases.

5. The method of claims 1—4 wherein the limited range has a variation of less than two percent about its midpoint value.

6. The method of any claims 1—5 wherein said temperature is varied by no more than two percent about a specified temperature value.

7. The method of any claims 1—6 wherein the temperature of said reactor is different than that of said substrate.

8. The method of any claims 1—7 wherein said different temperature is that of the body of said reactor.

9. The method of any claims 1—8 wherein the reactor temperature is greater than that of said reactor.

10. The method of any claims 1—9 wherein the temperature of said reaction is less than that of said reactor.

11. The method of any claims 1—10 wherein said reaction takes place in the temperature range between about 300°C and about 475°C.

## Patentansprüche

1. Verfahren zur Herstellung amorpher Halbleiter-Bauteile mit einem bestimmten Bandabstand, wobei wenigstens ein Halbleiter höherer Ordnung, der in einer Gasphasenmischung (G) enthalten ist, einer Reaktionskammer (100, 260) zugeführt ist, in welcher ein Substrat (130, 262) vorgesehen ist, wobei das Substrat gesteuert aufheizbar ist, dadurch gekennzeichnet, daß die Gasphasenmischung (G) pyrolytisch über dem erhitzten Substrat (130; 262) zerfällt und einen amorphen Halbleiter auf der Oberfläche des Substrats (130, 262) innerhalb eines Reaktionstemperaturbereichs zwischen 300°C und 500°C bildet, wobei die Temperatur des Substrats bei entsprechender Veränderung des Bandabstands des abgelagerten Materials verändert und konstant gehalten wird.

2. Verfahren nach Anspruch 1, dadurch gekennzeichnet, daß der Halbleiter der Silicium- oder Germaniumgruppe angehört oder eine Legierung dieser Elemente ist.

3. Verfahren nach Anspruch 1 oder 2, dadurch gekennzeichnet, daß der Bandabstand abnimmt wenn der Mittelwert des genannten Temperaturbereichs ansteigt.

4. Verfahren nach einem der Ansprüche 1 bis 3, dadurch gekennzeichnet, daß der Bandabstand und der Wasserstoffgehalt abnehmen wenn die Temperatur ansteigt.

5. Verfahren nach einem der Ansprüche 1 bis 4, dadurch gekennzeichnet, daß der Temperaturbereich um weniger als 2% um seinen Mittelwert schwankt.

6. Verfahren nach einem der Ansprüche 1 bis 5, dadurch gekennzeichnet, daß die Temperatur um nicht mehr als 2%, bezogen auf einen bestimmten Temperaturwert, verändert wird.

7. Verfahren nach einem der Ansprüche 1 bis 6, dadurch gekennzeichnet, daß die Temperatur des Reaktors von jener des Substrats abweicht.

8. Verfahren nach einem der Ansprüche 1 bis 7, dadurch gekennzeichnet, daß die abweichende Temperatur jener des Reaktorgehäuses entspricht.

9. Verfahren nach einem der Ansprüche 1 bis 8, dadurch gekennzeichnet, daß die Reaktionstemperatur höher ist als jene des Reaktors.

10. Verfahren nach einem der Ansprüche 1 bis 8, dadurch gekennzeichnet, daß die Reaktionstemperatur kleiner ist als jene des Reaktors.

11. Verfahren nach einem der Ansprüche 1 bis 10, dadurch gekennzeichnet, daß die Reaktion in einem Temperaturbereich zwischen etwa 300°C und etwa 475°C stattfindet.

## Revendications

1. Méthode de production de composants semiconducteurs amorphes avec une largeur de bande interdite spécifiée selon laquelle au moins un semi-conducteur d'ordre plus élevé contenu dans mélange de phase gazeuse (G) est introduit dans une chambre de réaction (100, 260) dans laquelle se trouve un substrat (130; 262), ledit substrat étant soumis à un chauffage contrôlé, caractérisée en ce que ledit mélange de phase gazeuse (G) se décompose pyrolytiquement sur ce substrat chauffé (130; 262) et forme un composant semi-conducteur amorphe sur la surface supérieure dudit substrat (130; 262) dans un intervalle de température compris entre 300°C et 500°C, la température dudit substrat étant modifiée et maintenue constante, ce qui modifie en conséquence la largeur de bande interdite dudit matériau déposé.

2. Méthode selon la revendication 1, où ledit semi-conducteur est choisi parmi la classe des silices ou des germanium, ou un alliage de ceux-ci.

3. Méthode selon la revendication 2, où la largeur de bande interdite diminue à mesure que la température moyenne dudit intervalle de température limité est augmentée.

4. Méthode selon l'une quelconque des revendications 1 à 3, où la largeur de bande interdite diminue et la quantité d'hydrogène diminue à mesure que la température augmente.

5. Méthode selon les revendications 1 à 4, où l'intervalle limité a une variation de moins de deux pour cent autour de sa valeur moyenne.

6. Méthode selon l'une quelconque des revendications 1 à 5, où ladite température est modifiée d'au plus deux pour cent de part et d'autre d'une valeur de température spécifiée.

7. Méthode selon l'une quelconque des revendications 1 à 6, où la température de ce réacteur est différente de celle dudit substrat.

8. Méthode selon l'une quelconque des revendications 1 à 7, où ladite température différente est celle du corps dudit réacteur.

9. Méthode selon l'une quelconque des revendications 1 à 8, où la température de ladite réaction est plus élevée que celle dudit réacteur.

10. Méthode selon l'une quelconque des revendications 1 à 9, où la température de ladite réaction est plus basse que celle dudit réacteur.

11. Méthode selon l'une quelconque des revendications 1 à 10, où ladite réaction se produit dans l'intervalle de température compris entre environ 300°C et environ 475°C.

FIGURE 1

100

```
┌─────────────────────────────────┐
│      INTRODUCE ONE OR MORE       │
│   GASEOUS PHASE POLYSILANES      │───── 101
│            INTO A                │
│       REACTION CHAMBER           │
└─────────────────────────────────┘
                 │
                 ▼
┌─────────────────────────────────┐
│      CONTROL TEMPERATURE,        │
│     CONDUCTANES AND/OR           │
│         PRESSURE IN              │───── 102
│      REACTION CHAMBER            │
└─────────────────────────────────┘
                 │
                 ▼
┌─────────────────────────────────┐
│    PYROLYTICALLY DECOMPOSE       │
│    THE POLYSILANES INTO          │───── 103
│     AMORPHOUS SILICON            │
│  HAVING A SPECIFIED BANDGAP      │
└─────────────────────────────────┘
```

FIG. 2

FIGURE 3

CHRONAR. A-SI:H ON X-SI

0 094 426

3

FIG. 4

# 0 094 426

FIG.5

Mass-Spec.
of
$Si_2H_6$

- No Moisture
- No HCl

$SiH_4$

$Si_2H_6$

$Si_3H_8$

$Si_xH_yN_zO_2$ (~ Background)

$H_2O$

20   40   60   80   92

5

FIGURE 6

0 094 426

FIG.7

7

FIG.8

H CONTENT ~ 3-4%

## FIG. 9

FIG 10

$E_A \approx 0.18 \, eV$